# EUROPÄISCHE PATENTSCHRIFT

(11) **EP 3 036 190 B1**
(45) Veröffentlichungstag und Bekanntmachung des Hinweises auf die Patenterteilung: **21.06.2017**
(21) Anmeldenummer: 14752592.7
(22) Anmeldetag: 07.08.2014
(51) Int. Cl.: C01B 33/02, C30B 15/00, C30B 29/06, B02C 1/10, B02C 13/28, B02C 2/00, B02C 4/30

(54) **POLYKRISTALLINE SILICIUMBRUCHSTÜCKE UND VERFAHREN ZUM ZERKLEINERN VON POLYKRISTALLINEN SILICIUMSTÄBEN**
POLYCRYSTALLINE SILICON FRAGMENTS AND PROCESS FOR COMMINUTING POLYCRYSTALLINE SILICON RODS
FRAGMENTS DE SILICIUM POLYCRISTALLIN ET PROCÉDÉ DE FRAGMENTATION DE BARREAUX DE SILICIUM POLYCRISTALLIN

(30) Priorität: 21.08.2013 DE 102013216557
(43) Veröffentlichungstag der Anmeldung: 29.06.2016
(73) Patentinhaber: Wacker Chemie AG, 81737 München (DE)
(72) Erfinder: PECH, Reiner, 84524 Neuötting (DE); GRUEBL, Peter, 94428 Eichendorf (DE)
(74) Vertreter: Potten, Holger
(86) Internationale Anmeldenummer: PCT/EP2014/067009
(87) Internationale Veröffentlichungsnummer: WO 2015/024789

(56) Entgegenhaltungen:
- EP-A1- 1 645 333
- EP-A1- 2 695 974
- EP-A2- 1 338 682
- AMARTYA MUKHOPADHYAY ET AL: "Recent developments on WC-based bulk composites", JOURNAL OF MATERIALS SCIENCE, KLUWER ACADEMIC PUBLISHERS, BO, Bd. 46, Nr. 3, 16. November 2010 (2010-11-16), Seiten 571-589, XP019870846, ISSN: 1573-4803, DOI: 10.1007/S10853-010-5046-7

## Beschreibung

Gegenstand der Erfindung sind polykristalline Silicumbruchstücke und ein Verfahren zum Zerkleinern von polykristallinen Siliciumstäben.

Im industriellen Maßstab wird Rohsilicium durch die Reduktion von Siliciumdioxid mit Kohlenstoff im Lichtbogenofen bei Temperaturen von etwa 2000 °C gewonnen.

Dabei erhält man sog. metallurgisches Silicium (Si_{mg,} "metallurgical grade") mit einer Reinheit von etwa 98-99 %.

Für Anwendungen in der Photovoltaik und in der Mikroelektronik muss das metallurgische Silicium gereinigt werden.

Dazu wird es beispielsweise mit gasförmigem Chlorwasserstoff bei 300-350 °C in einem Wirbelschichtreaktor zu einem Silicium enthaltenden Gas, beispielsweise Trichlorsilan, umgesetzt. Darauf folgen Destillationsschritte, um das Silicium enthaltende Gas zu reinigen.

Dieses hochreines Silicium enthaltende Gas dient dann als Ausgangsstoff für die Herstellung von hochreinem polykristallinem Silicium.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") dünne Filamentstäbe aus Silicium durch direkten Stromdurchgang erhitzt und ein Reaktionsgas enthaltend eine Silicium enthaltende Komponente und Wasserstoff wird eingeleitet.

Die Silicium enthaltende Komponente des Reaktionsgases ist in der Regel Monosilan oder ein Halogensilan der allgemeinen Zusammensetzung SiHₙX₄₋ₙ (n=0, 1, 2, 3; X = Cl, Br, I). Bevorzugt handelt es sich um ein Chlorsilan, besonders bevorzugt um Trichlorsilan. Überwiegend wird SiH₄ oder SiHCl₃ (Trichlorsilan, TCS) im Gemisch mit Wasserstoff eingesetzt.

Beim Siemens-Prozess stecken die Filamentstäbe üblicherweise senkrecht in am Reaktorboden befindlichen Elektroden, über die der Anschluss an die Stromversorgung erfolgt. Je zwei Filamentstäbe sind über eine waagrechte Brücke (ebenfalls aus Silicium) gekoppelt und bilden einen Trägerkörper für die Siliciumabscheidung. Durch die Brückenkopplung wird die typische U-Form der auch Dünnstäbe genannten Trägerkörper erzeugt.

An den erhitzten Stäben und der Brücke scheidet sich hochreines Polysilicium ab, wodurch der Stabdurchmesser mit der Zeit anwächst (CVD / Gasphasenabscheidung).

Nach Beendigung der Abscheidung werden diese Polysiliciumstäbe üblicherweise mittels mechanischer Bearbeitung zu Bruchstücken unterschiedlicher Größenklassen weiterverarbeitet, klassifiziert, gegebenenfalls einer nasschemischen Reinigung unterzogen und schließlich verpackt.

Im Stand der Technik sind mehrere Verfahren und Vorrichtungen zur Zerkleinerung von Polysilicium bekannt.

US 20070235574 A1 offenbart eine Vorrichtung zum Zerkleinern und Sortieren von polykristallinem Silicium, umfassend eine Aufgabeeinrichtung für einen Polysilicium-Grobbruch in eine Brecheranlage, die Brecheranlage, und eine Sortieranlage zum Klassieren des Polysilicium-Bruchs, dadurch gekennzeichnet, dass die Vorrichtung mit einer Steuerung versehen ist, die eine variable Einstellung mindestens eines Brechparameters in der Brecheranlage und/oder mindestens eines Sortierparameters in der Sortieranlage ermöglicht. Die Brecheranlage umfasst Walzenbrecher oder Backenbrecher, bevorzugt Stachelwalzenbrecher. Mittels des Verfahrens ist es möglich, gezielt nicht mehr fließfähigen kubischen Polysilicium-Bruch einer Größe von 45 bis 250 mm reproduzierbar in einer hohen Ausbeute herzustellen.

US 20100001106 A1 offenbart ein Verfahren zur Herstellung von hochreinem klassierten Polysilicium-Bruch, bei dem ein Polysilicium aus dem Siemens-Verfahren mittels einer Vorrichtung umfassend Zerkleinerungswerkzeuge und einer Siebvorrichtung zerkleinert und klassiert wird und der so erhaltene Polysilicium-Bruch mittels eines Reinigungsbades gereinigt wird, dadurch gekennzeichnet, dass die Zerkleinerungswerkzeuge und die Siebvorrichtung durchgängig eine mit dem Polysilicium in Kontakt kommende Oberfläche aus einem Werkstoff besitzen, welches den Polysilicium-Bruch nur mit solchen Fremdpartikeln verunreinigt, welche anschließend gezielt durch das Reinigungsbad entfernt werden. Die Zerkleinerung erfolgt in einer Brechanlage, die einen Walzenbrecher oder einen Backenbrecher, bevorzugt einen Stachelwalzenbrecher umfasst.

US 7270706 B2 offenbart jedoch eine perforierte Walze mit Zähnen, die um den Umfang der Walze herum angeordnet sind, eine Welle, auf der die Walze drehbar befestigt ist, ein Gehäuse mit Oberflächen, die einen Hohlraum bestimmen, innerhalb dessen die Walze angeordnet und/oder befestigt ist, einen Einlasskanal oben auf dem Gehäuse, einen Auslasskanal am Boden des Gehäuses, eine Platte innerhalb des Gehäuses gegenüber der Walze, wobei die Walze, die Zähne, die Platte und die Gehäuseoberflächen, die den Hohlraum bestimmen, hergestellt sind aus oder beschichtet sind mit einem Material, das eine Verunreinigung von polykristallinem Silicium minimiert. Das Material wird vorzugsweise ausgewählt aus der Gruppe, bestehend aus Carbiden, Kerametallen, Keramiken und Kombinationen davon. Besonders bevorzugt ist die Verwendung eines Materials ausgewählt aus der Gruppe, bestehend aus Wolframcarbid, Wolframcarbid mit einem Cobaltbinder, Wolframcarbid mit einem Nickelbinder, Titancarbid, Cr₃C₂, Cr₃C₂ mit Nickel-Chrom-Legierungsbinder, Tantalcarbid, Niobcarbid, Siliciumnitrid, Siliciumcarbid in einer Matrix, wie beispielsweise Fe, Ni, Al, Ti oder Mg, Aluminiumnitrid, Tantalcarbid, Niobcarbid, Titancarbid mit Cobalt- und Titancarbonitrid, Nickel, Nickel-Cobalt-Legierung, Eisen und Kombinationen davon.

US 20030159647 A1 offenbart eine Zerkleinerung von Polysilicium mittels eines Backenbrechers enthaltend Wolframcarbid in einer Cobaltmatrix (88% WC und 12% CO), wobei das WC-Korn eine Partikelgröße von 0,6 µm aufweist.

US 7950600 B2 offenbart ein Walzenbrecher umfassend eine Walze, welche sich mit einer Welle dreht, dadurch gekennzeichnet, dass die Walze aus einer Trägerwalze aus Stahl und aus mehreren Hartmetall-Segmenten besteht, wobei die Hartmetall-Segmente aus einer Cobaltmatrix, in die Wolframcarbid eingelagert ist, besteht und die Hartmetall-Segmente formschlüssig reversibel auf der Trägerwalze befestigt sind. Die Hartmetall-Segmente bestehen zu mehr als 80 Gew.-%, besonders bevorzugt zu mehr als 90 Gew.-%, insbesondere bevorzugt zu 91,5 Gew.-% aus Wolframcarbid, das in die Cobaltmatrix eingelagert ist.

US 7549600 B2 beschreibt einen Brecher, der zur Erzeugung von halbleiter- oder solartauglichem Siliciumfeinbruch aus halbleiter- oder solartauglichem Siliciumbruch geeignet ist, umfassend mehrere Brechwerkzeuge, wobei die Brechwerkzeuge eine Oberfläche aus einem harten, verschleißfesten Material besitzen, dadurch gekennzeichnet, dass der Brecher ein Zerkleinerungsverhältnis von 1,5 bis 3 aufweist, wobei die Brechwerkzeuge eine Oberfläche aus Hartmetall, bevorzugt Wolframcarbid in einer Kobaltmatrix, besonders bevorzugt mit einem Anteil an Wolframcarbid grösser 80 Gew.-%, besitzen.

Bekannt ist bereits, dass eine geringe Kontamination des Polysiliciums mit Wolfram durch geeignete Prozessführung erreicht werden kann, siehe z.B. US7549600 (B2) und die dort genannten Beispiele.

Bekannt sind auch Verfahrensschritte nach dem Brechen mit Wolframcarbid, um die Kontamination mit Wolfram zu reduzieren, siehe z.B. US 20100001106 A1 oder US 20120052297 A1.

Prinzipiell wurde im Stand der Technik und nach allgemeinem Fachwissen davon ausgegangen, dass durch eine höhere Härte des Hartmetalls, z.B. durch einen höheren W-Anteil oder durch eine Reduzierung der WC-Korngröße, ein höherer Verschleißwiederstand resultiert. Im Stand der Technik werden ausgehend von einer Korngröße von ca. 0,6 µm steigende W-Anteile von 80% mit Tendenz zu > 90% W genannt, siehe z.B. US20030159647 A1 und US 7950600 B2.

Allerdings hat sich gezeigt, dass härtere Werkzeuge auch spröder werden und zusätzliche unerwünschte Kontamination des Produkts durch Bruch des Werkzeugmaterials zu befürchten ist.

Aus dieser Problematik ergab sich die Aufgabenstellung der Erfindung.

Die Aufgabe wird gelöst durch das Verfahren nach Anspruch 1. Bevorzugte Ausführungsformen sind den abhängigen Ansprüchen und der nachfolgenden Beschreibung zu entnehmen.

Die Erfindung führt zu neuartigen polykristallinen Siliciumbruchstücken nach den Ansprüchen 10 und 11. Bevorzugte Ausführungen dieses Erzeugnisses werden nachfolgend offenbart.

Die Erfindung bezieht sich auf ein Verfahren zum Zerkleinern von polykristallinen Siliciumstäben in Bruchstücke mittels wenigstens eines Zerkleinerungswerkzeugs mit einer Oberfläche enthaltend Wolframcarbid, wobei die Werkzeugoberfläche einen Wolframcarbidanteil von kleiner oder gleich 95 % aufweist und die Korngröße der Wolframcarbid-Partikel (nach Masse gewichtet) im Mittel größer oder gleich 0,8 µm beträgt oder wobei die Werkzeugoberfläche einen Wolframcarbidanteil von größer oder gleich 80 % aufweist und die Korngröße der Wolframcarbid-Partikel kleiner oder gleich 0,5 µm beträgt.

Der Rest zu 100% im Werkstoff der Werkzeugoberfläche ist vorzugsweise Kobaltbinder, der auch bis zu 2%, bevorzugt jedoch weniger als 1 %, an anderen Metallen beinhalten kann.

Zusatzcarbide sind vorzugsweise zu weniger als 1% enthalten, davon Cr₃C₂ und VC < 0,4%.

Das Sinterergebnis wird auch durch Zugabe von Kohlenstoff beeinflusst. Es ist weiter bekannt, dass eine ausgeglichene Kohlenstoffbilanz wichtig zur Erzielung der optimalen Eigenschaften des Hartmetalls ist. Rückschlüsse darüber können z.B. über die magnetische Sättigung gezogen werden, die im Bereich von 7 - 14 µTm^3/kg, bzw. 75 - 110 % liegen kann. Der Kohlenstoffgehalt bezogen auf WC liegt bei ca. 6%, tendenziell etwas darüber.

Zum Zerkleinern von polykristallinen Siliicumstäben eignen sich Handhammer, Hammermühle, maschinelle Schlagwerkzeuge, wobei in diesem Fall vorzugsweise das gröbere Korn mit Korngröße größer oder gleich 0,8 µm zum Einsatz kommt.

Ebenso ist die Verwendung von Backen- und Walzenbrechern und Kugelmühlen vorgesehen, wobei in diesen Fällen vorzugsweise das feinere Korn kleiner oder gleich 0,5 µm zum Einsatz kommt.

Das feinere Korn weist vorzugsweise eine Korngröße von kleiner oder gleich 0,2 µm auf, in Kombination mit einem Wolframcarbidanteil von größer als 80 %, bevorzugt größer als 90%, besonders bevorzugt größer als 95%.

Das gröbere Korn weist vorzugsweise eine Korngröße von größer oder gleich 1,3 µm auf, in Kombination mit einem Wolframcarbidanteil von weniger als 95 %, bevorzugt weniger als 90%, besonders bevorzugt 65-80%.

Vorzugsweise umfasst das Verfahren wenigstens zwei Zerkleinerungsschritte, wobei der abschließende Zerkleinerungsschritt mit einem Zerkleinerungswerkzeug erfolgt, das einen höheren Wolframcarbidanteil oder eine niedrigere Korngröße der Wolframcarbid-Partikel aufweist als das bei einem der vorangegangenen Zerkleinerungsschritte verwendete Zerkleinerungswerkzeug.

Vorzugsweise umfasst das Verfahren wenigstens zwei Zerkleinerungsschritte: wenigstens einen Zerkleinerungsschritt mit einem Zerkleinerungswerkzeug mit einer Korngröße der Wolframcarbid-Partikel von größer oder gleich 0,8 µm, bevorzugt größer oder gleich 1,3 µm oder wenigstens einen Zerkleinerungsschritt mit einem Zerkleinerungswerkzeug mit einer Korngröße der Wolframcarbid-Partikel von kleiner oder gleich 0,5 µm, bevorzugt kleiner oder gleich 0,2 µm.

Vorzugsweise umfasst das Verfahren wenigstens zwei Zerkleinerungsschritte, gekennzeichnet dadurch, dass die dabei verwendeten wenigstens zwei Zerkleinerungswerkzeuge unterschiedliche WC-Korngrößen haben, ausgewählt aus der Gruppe bestehend aus WC-Korngröße kleiner als 0,5µm, WC-Korngröße 0,5-0,8 µm, WC-Korngröße größer als 0,8µm.

Besonders bevorzugt ist es, wenn das Verfahren wenigstens einen Zerkleinerungsschritt mit einem Zerkleinerungswerkzeug mit einer Korngröße der Wolframcarbid-Partikel von größer oder gleich 0,8 µm und einen Zerkleinerungsschritt mit einem Zerkleinerungswerkzeug mit einer Korngröße der Wolframcarbid-Partikel von kleiner oder gleich 0,5 µm umfasst.

Vorzugsweise umfasst das Verfahren wenigstens einen Zerkleinerungsschritt durch WC-Werkzeuge mit geringem WC-Anteil (<90%, bevorzugt <85%) und/oder größerem Korn > 0,8 µm und wenigstens einen weiteren Zerkleinerungsschritt durch WC-Werkzeuge mit zunehmend höheren WC-Anteil (>90, bevorzugt >95%) und/oder kleinerem Korn < 0,5 µm.

Vorzugsweise erfolgen der letzte Zerkleinerungsschritt, besonders bevorzugt die letzten beiden Zerkleinerungsschritte, mit WC-Werkzeugen mit WC-Anteil >85%, bevorzugt > 90% und /oder einer Korngröße < 0,5 µm, besonders bevorzugt < 0,2 µm.

Vorzugsweise erfolgt nach der Zerkleinerung der Stäbe, bevorzugt nach dem zweiten Zerkleinerungsschritt, eine thermischer Behandlung der Bruchstücke bei einer Temperatur von > 500°C mit anschließendem Abschrecken in einem kälterem Medium, gefolgt von weiteren Zerkleinerungsschritten.

Es hat sich gezeigt, dass durch das erfindungsgemäße Verfahren zum Brechen von polykristallinen Siliciumstäben, polykristalline Siliciumbruchstücke mit WC-Partikeln auf der Oberfläche resultieren, wobei die WC-Partikel im Mittel eine Größe von kleiner als 0,5 µm oder im Mittel eine Größe von größer als 0,8 µm aufweisen.

Vorzugsweise beträgt die mittlere Größe der WC-Partikel weniger als 0,2 µm.

Vorzugsweise beträgt die mittlere Größe der WC-Partikel größer als 1,3 µm.

Ebenso können polykristalline Siliciumbruchstücke erzeugt werden, die WC-Partikel an ihrer Oberfläche aufweisen, wobei die Partikelgrößen der WC-Partikel auf der Oberfläche bi- oder multimodal verteilt sind, mit wenigstens einem Maximum der Verteilung bei kleiner als 0,6 µm und / oder wenigstens einem Maximum der Verteilung bei größer 0,6 µm.

Vorzugsweise liegt wenigstens ein Maximum der Verteilung bei kleiner als 0,5 µm.

Besonders bevorzugt liegt wenigstens ein Maximum der Verteilung bei kleiner als 0,2 µm.

Vorzugsweise liegt wenigstens ein Maximum der Verteilung bei größer als 0,8 µm.

Besonders bevorzugt liegt wenigstens ein Maximum der Verteilung bei größer als 1,3 µm.

Überraschenderweise hat sich herausgestellt, dass der Wolframcarbidanteil, bzw. die Härte einen weit geringeren Einfluss auf den Abrieb hat, als die bisher nicht beachtete Korngröße der WC-Partikel der Zerkleinerungswerkzeuge. Bei gleicher Härte zeigte nämlich ein Werkzeug mit kleineren Korn und geringerem Wolframcarbidanteil einen deutlich geringeren Abrieb, als ein Werkzeug mit größerem Korn und höherem WC-Anteil.

Überraschend war auch, dass die Wolframkontamination auf dem Polysilicium bei mehreren Zerkleinerungsschritten vorwiegend durch den letzten Zerkleinerungsschritt bestimmt wird.

Damit wird bei einem Verfahren, das mehrere Zerkleinerungsschritte umfasst, der Einsatz von weniger verschleißfesten, aber zähen Hartmetallwerkzeugen bei den anfänglichen Zerkleinerungsschritten, z. B. beim Vorbrechen, ermöglicht. Dies ist von Vorteil. Beim letzten Zerkleinerungsschritt sollte dagegen darauf geachtet werden, dass ein Werkzeug mit einer besonders geeigneten WC-Sorte, nämlich mit feinerer WC-Korngröße und/oder höherem Wolframcarbidanteil, zum Einsatz kommt.

Die erfindungsgemäßen polykristallinen Siliciumbruchstücke, die sich durch WC-Partikel an der Oberfläche mit definierten Partikelgrößen oder Partikelgrößenverteilungen auszeichnen, weisen ebenfalls überraschende Vorteile auf.

Diese werden dann sichtbar, wenn das Polysilicium aufgeschmolzen und bei den Kunden z.B. durch Kristallziehen zu Einkristallen für Solar- oder Halbleiteranwendungen weiterverarbeitet wird.

Der Einfluss der WC-Korngröße bei Zerkleinerungswerkzeugen auf das Aufschmelzverhalten bzw. die Ziehperformance beim Kunden war unvorhersehbar.

Grundsätzlich können WC-Partikel an der Oberfläche von Polysilicium (wie auch andere Fremdstoffe / Metalle) beim Kristallziehen zu Versetzungen führen. Beispielsweise ist denkbar, dass sehr große WC-Partikel aufgrund des sehr hohen Schmelzpunktes von ca. 2800°C nicht aufgeschmolzen werden und dadurch zu solchen Versetzungen führen. Auch kleinere Partikel, die zwar leichter aufschmelzbar sind, können bei gleicher Gesamtkontamination aufgrund ihrer deutlich höheren Anzahl - bis über Faktor 1000 - zu Versetzungen beim Einkristallziehen führen.

Die Erfinder konnten jedoch zeigen, dass mit dem Einsatz von WC mit größerem Korn als auch mit kleinerem Korn bessere Ergebnisse erreicht werden, als mit dem Korn nach Stand der Technik, nämlich Feinkorn mit ~ 0,6µm, vgl. US2003159647 A1.

Insbesondere bevorzugt ist eine mit jedem Brechschritt abnehmende Korngröße.

Besonders bevorzugt wird zum Vorbrechen eine WC-Sorte mit großem Korn (> 0 ,8 µm) verwendet, und für die letzten oder den letzten Brechschritt eine WC-Sorte mit kleinem Korn (< 0,5 µm).

Insbesondere aber lassen sich bessere Ergebnisse durch die Kombination von mehreren Zerkleinerungsschritten mit Werkzeugen verschiedenen Korngrößen, nämlich geringere Kontamination, höhere Standzeiten und bessere Ziehperformance, erreichen. Die Dimensionen der Bearbeitungswerkzeuge können erhöht werden und damit Prozesse mit höherem Durchsatz und niedrigeren Kosten gefahren werden.

Es ist zudem keine aufwändige Nachbearbeitung der Bruchstücke, wie z.B. durch eine nasschemische Reinigung, erforderlich. Insgesamt wird der Herstellungsprozess deutlich wirtschaftlicher.

### Beispiele

Beim Zerkleinern in Bruchstücke ergeben sich Bruchgrößen (BG), die folgenden Größenklassen zugeordnet werden können, die jeweils als längste Entfernung zweier Punkte auf der Oberfläche eines Siliciumbruchstücks (=max. Länge) definiert sind:
Bruchgröße 0 [mm] 1 bis 5;
Bruchgröße 1 [mm] 4 bis 15;
Bruchgröße 2 [mm] 10 bis 40;
Bruchgröße 3 [mm] 20 bis 60;
Bruchgröße 4 [mm] 45 bis 120;
Bruchgröße 5 [mm] 90 bis 200
Bruchgröße 6 [mm] 130 bis 400

### Beispiel 1

Manuelles Brechen von Polykristallinen Siliciumstäben mit einem Handhammer (WC in Co-Matrix)
a. (Stand der Technik) 88% WC, 12% Co und Feinkorn (0,5-0,8 µm): kleine, visuell sichtbare WC-Absplitterungen, d.h. hohe Kontamination
b. 88% WC, 12% Co und Grobkorn (2,5-6,0 µm): Keine visuell sichtbaren WC-Absplitterungen, d.h. geringe Kontamination
c. 80% WC, 20%Co und Feinkorn (0,5-0,8 µm): Keine visuell sichtbaren WC-Absplitterungen

### Beispiel 2

Vorbrechen wie nach **Beispiel 1** b. und weiteres Brechen mit einem Walzenbrecher auf Zielgröße BG4, Klassieren und Analyse der Oberflächenkontamination von Probestücken einer Teilfraktion nach Stand der Technik mit ICPMS (ICP=inductively coupled plasma) nach DIN 51086-2; Angaben zur Härte nach Vickers, Prüfkraft 10 kp).
a. (Stand der Technik) Härte HV10 1650: 90% WC + 10% Co, Feinstkorn (0,5 µm bis 0,8 µm): BG1 Wolfram 2000 pptw
b. Härte HV10 1630: 94% WC + 6% Co, Feinkorn (0,8 µm bis 1,3 µm): BG1 Wolfram 4000pptw
c. Härte HV10 1590: 85% WC + 15% Co; Ultrafeintkorn (0,2-0,5 µm): BG1 Wolfram 1000pptw

### Beispiel 3

Manuelles Vorbrechen nach **Beispiel 1** b., dann weiteres Brechen zu Zielgröße BG2 mit großem Backenbrecher (88% WC & 12% Co und Feinstkorn (0,5-0,8 µm)), dann zwei Brechschritte mit einem kleineren Backenbrecher (88% WC & 12 %Co Feinstkorn (0,5 µm bis 0,8 µm)) und einem letzten Brechschritt
a. mit Backenbrecher (88% WC & 12 %Co Feinstkorn (0,5 µm bis 0, 8µm): BG 2 Wolfram 500 pptw (Stand der Technik), oder
b. mit Backenbrecher (93,5% WC & 6,5% Co Ultrafeinkorn (0,2 µm bis 0,5 µm): BG2 Wolfram 200 pptw
(a. und b. bei jeweils etwa gleichem Zerkleinerungsverhältnis)

### Beispiel 4

wie **Beispiel 3** b., aber mit thermischer 800° /1 h Vorbehandlung und anschließendem Abschrecken in 20° kaltem Wasser und Vakuumtrocknung nach dem zweiten Brechschritt.
Ergebnis: BG2 Wolfram 50pptw

### Beispiel 5

Poly-Si-Stäbe werden gezielt mit mehreren Brechschritte und unterschiedlichen WC-Sorten auf BG2 gebrochen, so dass das Endprodukt der Vergleichsgruppen jeweils in etwa die gleiche W-Kontamination von ca. 500 pptw aufweist, sich jede Gruppe aber durch die Korngröße auf dem Produkt unterscheidet.
Anschließend wurde das Material mit dem CZ-Verfahren zu einem Einkristall gezogen und die versetzungsfreie Länge vermessen.

Die mittlere versetzungsfreie Länge wird bestimmt aus dem Verhältnis von möglicher zylindrischer Kristallstablänge (berechnet aus Einwaage minus Konus und Restschmelzenverluste) und tatsächlicher Länge mehrere Kristalle.
a. (Stand der Technik) Manuelles Vorbrechen (88% WC / 12% Co / Feinstkorn 0,5-0,8µm) auf BG4, gefolgt von zwei Brechschritten mit einem Backenbrecher ( 88% WC / 12% Co / Korn 0,5-0,8µm) auf BG2:
   versetzungsfreie Länge ~70%
b. Manuelles Vorbrechen (88% WC / 12% Co / Grobkorn 2,5-6,0µm) auf BG4, drei Brechschritte mit einem Backenbrecher ( 88% WC / 12% Co / Grobkorn 2,5-6,0µm) auf BG2:
   versetzungsfreie Länge ~95%
c. Manuelles Vorbrechen (88% WC / 12% Co / Ultrafeinkorn 0,2-0,5µm) auf BG4, ein Brechschritt mit einem Backenbrecher ( 88% WC / 12% Co / Ultrafeinkorn 0,2-0,5µm) auf BG2:
   versetzungsfreie Länge ~93%

## Patentansprüche

1. Verfahren zum Zerkleinern von polykristallinen Siliciumstäben in Bruchstücke mittels wenigstens eines Zerkleinerungswerkzeugs mit einer Oberfläche enthaltend Wolframcarbid, wobei die Werkzeugoberfläche einen Wolframcarbidanteil von kleiner oder gleich 95 % aufweist und die Korngröße der Wolframcarbid-Partikel - nach Masse gewichtet im Mittel - größer oder gleich 0,8 µm beträgt oder wobei die Werkzeugoberfläche einen Wolframcarbidanteil von größer oder gleich 80 % aufweist und die Korngröße der Wolframcarbid-Partikel kleiner oder gleich 0,5 µm beträgt, **dadurch gekennzeichnet, dass** das Verfahren wenigstens zwei Zerkleinerungsschritte umfasst, davon wenigstens einen Zerkleinerungsschritt mit einem Zerkleinerungswerkzeug mit einer Korngröße der Wolframcarbid-Partikel von größer oder gleich 0,8 µm, bevorzugt größer oder gleich 1,3 µm oder wenigstens einen Zerkleinerungsschritt mit einem Zerkleinerungswerkzeug mit einer Korngröße der Wolframcarbid-Partikel von kleiner oder gleich 0,5 µm, bevorzugt kleiner oder gleich 0,2 µm.

2. Verfahren nach Anspruch 1, wobei es sich beim wenigstens einen Zerkleinerungswerkzeug um einen Handhammer, eine Hammermühle oder um ein maschinelles Schlagwerkzeug handelt, wobei die Korngröße der Wolframcarbid-Partikel größer oder gleich 0,8 µm beträgt.

3. Verfahren nach Anspruch 1, wobei es sich beim wenigstens einen Zerkleinerungswerkzeug um einen Backenbrecher, einen Walzenbrecher oder um eine Kegelmühle handelt, wobei die Korngröße der Wolframcarbid-Partikel kleiner oder gleich 0,5 µm beträgt.

4. Verfahren nach einem der Ansprüche 1 bis 3, wobei die Korngröße der Wolframcarbid-Partikel kleiner oder gleich 0,2 µm beträgt und der Wolframcarbidanteil größer als 80 %, bevorzugt größer als 90%, besonders bevorzugt größer als 95% beträgt.

5. Verfahren nach einem der Ansprüche 1 bis 3, wobei die Korngröße der Wolframcarbid-Partikel größer oder gleich 1,3 µm beträgt und der Wolframcarbidanteil weniger als 95 %, bevorzugt weniger als 90%, besonders bevorzugt 80% bis 65% beträgt.

6. Verfahren nach einem der Ansprüche 1 bis 5, wobei wenigstens ein Zerkleinerungsschritt mit einem Zerkleinerungswerkzeug mit einer Korngröße der Wolframcarbid-Partikel von größer oder gleich 0,8 µm und wenigstens ein Zerkleinerungsschritt mit einem Zerkleinerungswerkzeug mit einer Korngröße der Wolframcärbid-Partikel von kleiner oder gleich 0,5 µm erfolgen.

7. Verfahren nach einem der Ansprüche 1 bis 6, umfassend wenigstens zwei Zerkleinerungsschritte, nämlich wenigstens einen Zerkleinerungsschritt mit einem Zerkleinerungswerkzeug mit einem Wolframcarbidanteil von kleiner als 90%, bevorzugt kleiner als 85% , und wenigstens einen Zerkleinerungsschritt mit einem Zerkleinerungswerkzeug mit einem Wolframcarbidanteil von größer als 90%, bevorzugt größer als 95%.

8. Verfahren nach einem der Ansprüche 1 bis 7, umfassend wenigstens zwei Zerkleinerungsschritte, wobei der abschließende Zerkleinerungsschritt mit einem Zerkleinerungswerkzeug erfolgt, das einen höheren Wolframcarbidanteil oder eine niedrigere Korngröße der Wolframcarbid-Partikel aufweist als das bei einem der vorangegangenen Zerkleinerungsschritte verwendete Zerkleinerungswerkzeug.

9. Verfahren nach einem der Ansprüche 1 bis 8, wobei zwischen zwei Zerkleinerungsschritten, bevorzugt nach dem ersten, eine thermische Behandlung der Bruchstücke bei einer Temperatur von größer als 500°C mit anschließendem Abschrecken in einem kälterem Medium erfolgt.

## Claims

1. A process for comminuting polycrystalline silicon rods into chunks by means of at least one comminuting tool having a surface comprising tungsten carbide, wherein the tool surface has a tungsten carbide content of less than or equal to 95% and the median grain size of the tungsten carbide particles - weighted by mass - is greater than or equal to 0.8 µm, or wherein the tool surface has a tungsten carbide content of greater than or equal to 80% and the median grain size of the tungsten carbide particles is less than or equal to 0.5 µm, **characterized in that** the process comprises at least two comminution steps, at least one of them a comminution step with a comminuting tool having a grain size of the tungsten carbide particles of greater than or equal to 0.8 µm, preferably greater than or equal to 1.3 µm, or at least one comminution step with a comminuting tool having a grain size of the tungsten carbide particles of less than or equal to 0.5 µm, preferably less than or equal to 0.2 µm.

2. Process according to Claim 1, wherein the at least one comminuting tool is a manual hammer, a hammer mill or a machine impact tool, wherein the grain size of the tungsten carbide particles is greater than or equal to 0.8 µm.

3. Process according to Claim 1, wherein the at least one comminuting tool is a jaw crusher, a roll crusher or a ball mill, wherein the grain size of the tungsten carbide particles is less than or equal to 0.5 µm.

4. Process according to any of Claims 1 to 3, wherein the grain size of the tungsten carbide particles is less than or equal to 0.2 µm and the tungsten carbide content is greater than 80%, preferably greater than 90%, more preferably greater than 95%.

5. Process according to any of Claims 1 to 3, wherein the grain size of the tungsten carbide particles is greater than or equal to 1.3 µm and the tungsten carbide content is less than 95%, preferably less than 90%, more preferably 80% to 65%.

6. Process according to any of Claims 1 to 5, wherein at least one comminution step is effected with a comminuting tool having a grain size of the tungsten carbide particles of greater than or equal to 0.8 µm, and at least one comminution step with a comminuting tool having a grain size of the tungsten carbide particles of less than or equal to 0.5 µm.

7. Process according to any of Claims 1 to 6, comprising at least two comminution steps, namely at least one comminution step with a comminuting tool having a tungsten carbide content of less than 90%, preferably less than 85%, and at least one comminution step with a comminuting tool having a tungsten carbide content of greater than 90%, preferably greater than 95%.

8. Process according to any of Claims 1 to 7, comprising at least two comminution steps, the final comminution step being effected with a comminuting tool having a higher tungsten carbide content or a lower grain size of the tungsten carbide particles than in the comminuting tool used in one of the preceding comminution steps.

9. Process according to any of Claims 1 to 8, wherein a thermal treatment of the chunks at a temperature of greater than 500°C with subsequent quenching in a colder medium is effected between two comminution steps, preferably after the first comminution step.

## Revendications

1. Procédé pour le broyage de bâtons de silicium polycristallin en fragments au moyen d'au moins un outil de broyage présentant une surface contenant du carbure de tungstène, la surface d'outil présentant une proportion de carbure de tungstène inférieure ou égale à 95% et la grosseur des particules de carbure de tungstène - moyenne pondérée en masse - étant supérieure ou égale à 0,8 µm ou la surface d'outil présentant une proportion de carbure de tungstène supérieure ou égale à 80% et la grosseur des particules de carbure de tungstène étant inférieure ou égale à 0,5 µm, **caractérisé en ce que** le procédé comprend au moins deux étapes de broyage, dont au moins une étape de broyage avec un outil de broyage présentant une grosseur des particules de carbure de tungstène supérieure ou égale à 0,8 µm, de préférence supérieure ou égale à 1,3 µm, ou au moins une étape de broyage avec un outil de broyage présentant une grosseur des particules de carbure de tungstène inférieure ou égale à 0,5 µm, de préférence inférieure ou égale à 0,2 µm.

2. Procédé selon la revendication 1, ledit au moins un outil de broyage étant un marteau, un broyeur à marteaux ou une machine-outil de percussion, la grosseur des particules de carbure de tungstène étant supérieure ou égale à 0,8 µm.

3. Procédé selon la revendication 1, ledit au moins un outil de broyage étant un concasseur à mâchoires, un concasseur à cylindres ou un broyeur à cônes, la grosseur des particules de carbure de tungstène étant inférieure ou égale à 0,5 µm.

4. Procédé selon l'une quelconque des revendications 1 à 3, la grosseur des particules de carbure de tungstène étant inférieure ou égale à 0,2 µm et la proportion de carbure de tungstène étant supérieure à 80%, de préférence supérieure à 90%, de manière particulièrement préférée supérieure à 95%.

5. Procédé selon l'une quelconque des revendications 1 à 3, la grosseur des particules de carbure de tungstène étant supérieure ou égale à 1,3 µm et la proportion de carbure de tungstène étant inférieure à 95%, de préférence inférieure à 90%, de manière particulièrement préférée de 80% à 65%.

6. Procédé selon l'une quelconque des revendications 1 à 5, au moins une étape de broyage ayant lieu avec un outil de broyage présentant une grosseur des particules de carbure de tungstène supérieure ou égale à 0,8 µm et au moins une étape de broyage ayant lieu avec un outil de broyage présentant une grosseur des particules de carbure de tungstène inférieure ou égale à 0,5 µm.

7. Procédé selon l'une quelconque des revendications 1 à 6, comprenant au moins deux étapes de broyage, à savoir au moins une étape de broyage avec un outil de broyage présentant une proportion de carbure de tungstène inférieure à 90%, de préférence inférieure à 85%, et au moins une étape de broyage avec un outil de broyage présentant une proportion de carbure de tungstène supérieure à 90%, de préférence supérieure à 95%.

8. Procédé selon l'une quelconque des revendications 1 à 7, comprenant au moins deux étapes de broyage, l'étape de broyage final ayant lieu avec un outil de broyage qui présente une proportion de carbure de tungstène supérieure ou une grosseur des particules de carbure de tungstène inférieure à celles de l'outil de broyage utilisé lors d'une des étapes de broyage préalables.

9. Procédé selon l'une quelconque des revendications 1 à 8, un traitement thermique des fragments, à une température supérieure à 500°C avec un refroidissement brusque consécutif dans un milieu plus froid, étant réalisé entre les deux étapes de broyage, de préférence après la première.
